# EUROPEAN PATENT APPLICATION

(11) **EP 4 306 675 A1**
(43) Date of publication of application: **17.01.2024**
(21) Application number: 22766953.8
(22) Date of filing: 02.03.2022
(51) Int. Cl.: C23C 16/40, B01D 53/04, B01J 20/18, B01J 20/30, C01B 39/02, C23C 16/18, C23C 16/455

(54) **METHOD FOR PRODUCING ZEOLITE MEMBRANE, GAS ADSORBENT, AND GAS ADSORPTION DEVICE**

(30) Priority: 08.03.2021 JP 2021036246
(71) Applicant: Creative Coatings Co., Ltd., Tokyo, 113-0023 (JP)
(72) Inventor: SATO, Eiji, Tokyo 162-0842 (JP); SAKAMOTO, Hitoshi, Tokyo 162-0842 (JP)
(74) Representative: Wunderlich & Heim Patentanwälte Partnerschaftsgesellschaft mbB
(86) International application number: PCT/JP2022/008877
(87) International publication number: WO 2022/190994

(57) **Abstract**

A method for forming a zeolite membrane by performing an ALD cycle, the ALD cycle including a silicon oxide film forming step and an aluminum oxide film forming step. In the silicon oxide film forming step, an organic Si compound is used as a first raw material gas and OH radicals are used as a reaction gas; in the aluminum oxide film forming step, an organic Al compound is used as a second raw material gas and OH radicals are used as a reaction gas; and the silicon oxide films and the aluminum oxide films are alternately formed in forward or reverse order to form the zeolite membrane.

## Description

### TECHNICAL FIELD

This invention relates to a zeolite membrane production method, a gas adsorbent, a gas adsorption device, etc.

### BACKGROUND ART

Zeolite is known as a microporous adsorption material and has applications such as a gas adsorbent. As shown in Patent Document 1, a zeolite membrane on a porous support is formed by: a method for crystallizing the zeolite into a membrane on a porous support surface, a method for fixing the zeolite to the porous support with an inorganic binder, an organic binder, or the like, a method for fixing a polymer in which the zeolite is dispersed, or a method for impregnating the porous support with zeolite slurry and, in some cases, fixing the zeolite to the porous support through suction (see paragraph 0053, etc.). Here, the method for crystallizing the zeolite into the membrane on the porous support surface refers to a method for crystallizing RHO-type zeolite into a membrane on a porous support surface by hydrothermal synthesis or the like (see paragraph 0054, etc.).

### RELATED-ART DOCUMENT

### PATENT DOCUMENT

Patent Document 1: JP-A-2018-130719

### SUMMARY OF THE INVENTION

### TECHNICAL PROBLEM

An objective of the present invention is to provide a novel zeolite membrane production method for forming a zeolite membrane on a surface of an object by using a raw material gas and a reaction gas, a gas adsorbent, and a gas adsorption device.

### SOLUTION TO PROBLEM

(1) In accordance with one of some aspect, there is provided a zeolite membrane production method for forming a zeolite membrane on a surface of an object by performing an ALD cycle in a reaction vessel,
   the ALD cycle including a silicon oxide film forming step and an aluminum oxide film forming step,
   the silicon oxide film forming step including:
      a first step of filling an organic Si compound as a first raw material gas into the reaction vessel,
      a second step of exhausting the first raw material gas from the reaction vessel,
      a third step of filling OH radicals as a reaction gas into the reaction vessel, and
      a fourth step of exhausting the reaction gas from the reaction vessel,
   the aluminum oxide film forming step including:
      a fifth step of filling an organic Al compound as a second raw material gas into the reaction vessel,
      a sixth step of exhausting the second raw material gas from the reaction vessel,
      a seventh step of filling OH radicals as a reaction gas into the reaction vessel,
      an eighth step of exhausting the reaction gas from the reaction vessel, and
   the silicon oxide films and the aluminum oxide films being alternately formed in forward or reverse order.

According to one aspect of the invention, the zeolite membrane is formed by alternately forming the silicon oxide films and the aluminum oxide films in forward or reverse order. If the silicon oxide SiO₄ films and the aluminum oxide AlO₄ films are regularly arranged, the zeolite membrane as shown by the following chemical formula can be formed. This is because a basic unit of a zeolite structure is a tetrahedral structure of SiO₄ or AlO₄, and the units are linked in a three-dimensional direction to form a crystal. The zeolite is laminate of two types of layers at a moment of adsorption-oxidation, but it changes into a thermodynamically stable system (i.e., zeolite) with time.

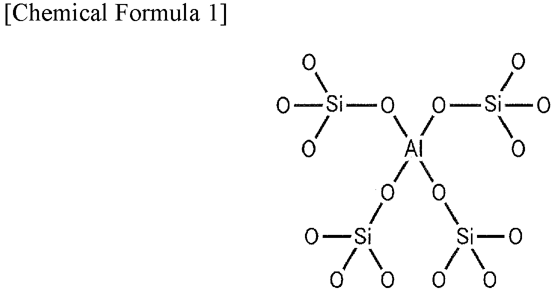

As two types of precursors to form the silicon oxide film, the organic Si compound of the first raw material gas and the hydroxyl group OH radicals (OH*) of the reaction gas are used. The organic Si compound of the first raw material gas adheres to an object surface, after it is filled into a reaction vessel in the first step and even exhausted in the second step. The OH radicals (OH*) of the reaction gas filled into the reaction vessel in the third step, react with the organic Si compound adhering to the object surface, to form the silicon oxide SiO₄ film on the object surface at an atomic layer level. In the fourth step, the OH radicals (OH*) are exhausted from the reaction vessel. Still, as the organic Si compound of the first raw material gas, TDMAS (Tris(dimethylamino)silane: SiH[N(CH₃)₂]₃), TEOS (Tetraethyl orthosilicate: Si(OC₂H₅)₄), OMCTS (Octamethylcyclotetrasiloxane: [OSi(CH₃)₂]₄), or TMCTS (Tetramethylcyclotetrasiloxane: [OSiH(CH₃)]₄), etc. can be used.

As two types of precursors to form the aluminum oxide film, the organic Al compound of the second raw material gas and hydroxyl group OH radicals (OH*) of the reaction gas are used. The organic Al compound of the second raw material gas adheres to the object surface, after it is filled into the reaction vessel in the fifth step and even exhausted in the sixth step. The OH radicals (OH*) of the reaction gas filled into the reaction vessel in the seventh step, react with the organic Al compound adhering to the object surface, to form the aluminum oxide AlO₄ film on the object surface at an atomic layer level. In the eighth step, the OH radicals (OH*) are exhausted from the reaction vessel. Still, as the organic Al compound of the second raw material gas, TMA (trimethylaluminium: Al(CH₃)₃), Al(O-sec-C₄H₉)₃ (Aluminum-tri-sec-butoxide), etc. can be used.

A set of the first through eighth steps is the ALD cycle, and by repeating this cycle, the silicon oxide films and the aluminum oxide films are alternately formed. Still, the silicon oxide films and the aluminum oxide films may be alternately laminated in forward or reverse order, and the first deposition on the object may be performed in the fifth through eighth steps, followed by the first through fourth steps. A film thickness of the zeolite membrane is proportional to cycle number of the ALD cycles repeatedly performed, and the desired film thickness can be achieved by adjusting the number of the cycles. This high-precision lamination extends a service life of the zeolite membrane, and since it functions well even with a thin film thickness, lower costs can be realized.
(2) According to one of some aspect (1), the object may be powder, and the zeolite membrane may be formed on a surface of the powder. Since the zeolite is a porous body with a micropore diameter corresponding to a molecular diameter, phenomena in which molecules entering the pores are adsorbed and remained in those pores occur. Although there is no limit to the object, the powder with the zeolite membrane formed on the surface can be used for a gas adsorbent and the like. Densely arranged the powder with the zeolite membrane formed on its surface allows some gases to be adsorbed into the pores while allowing other some gases to pass through.
(3) According to one of some aspect (2), the powder may be formed of aluminum oxide, and the silicon oxide film may be formed on a surface of the powder by performing the silicon oxide film forming step first in the ALD cycle. When it is done in this way, the aluminum oxide of the powder surface and the silicon oxide film formed on the top of it change into a thermodynamically stable system (zeolite) with time.
(4) According to one of some aspect (2), the powder may be formed of silicon oxide, and the aluminum oxide film may be formed on a surface of the powder by performing the aluminum oxide film forming step first in the ALD cycle. When it is done in this way, the silicon oxide of the powder surface and the aluminum oxide film formed on the top of it change into the thermodynamically stable system (zeolite) with time.
(5) According to one of some aspect (1), the object may be a porous material, and the zeolite membrane may be formed on a surface of the porous material. The porous body with the zeolite membrane on the surface can be utilized for a filter capable of gas adsorption and the like.
(6) In accordance with another one of some aspect, there is provided a gas adsorbent comprising
   a powder and
   a zeolite membrane covering a surface of the powder.

According to another aspect of the invention, the gas adsorbent that become capable to be formed for the first time by (2) to (4) of one aspect of the invention is defined. (7) In accordance with another one of some aspect, there is provided a gas adsorption device constituted by arranging a plurality of gas adsorbents densely, the plurality of gas adsorbents including the gas adsorbent according to one of some aspect (6).

According to yet another aspect of the invention, some gases can be adsorbed by the zeolite membrane formed on the surface of at least some, preferably all, of the plurality of gas adsorbents that are arranged densely.

### BRIEF DESCRIPTION OF THE DRAWINGS

FIG. 1 illustrates an ALD device in which a zeolite membrane production method that is one embodiment of the invention is performed.
FIG. 2 illustrates details of reaction gas sources illustrated in FIG. 1.
FIG. 3 is a timing chart for explaining an embodiment of an ALD method performed in the ALD device illustrated in FIG. 1.
FIG. 4 illustrates a respiratory oxygen concentrator that is one example of a gas adsorption device.

### DESCRIPTION OF EMBODIMENTS

### 1. ALD Device

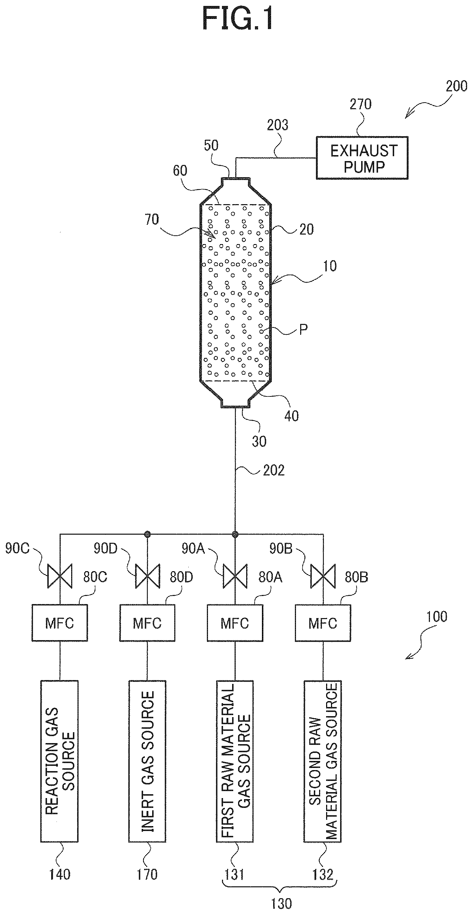

FIG. 1 illustrates one example of an ALD device 200 including a reaction vessel 10 and gas sources 100. The reaction vessel 10 can include a vessel body 20 accommodating powder P, a gas inlet port 30 for introducing gases from the gas sources 100 into the vessel body 20, a first filter 40 disposed inside the vessel body 20, an exhaust port 50 for exhausting the inside of the vessel body 20, and a second filter 60 disposed inside the vessel body 20. The first filter 40 allows passage of gases while preventing the powder P from passing toward the gas inlet port 30. The second filter 60 allows passage of the gases while preventing the powder P from passing toward the exhaust port 50. The powder P are then accommodated in capable of putting in and out of a powder compartment 70, that is partitioned by the vessel body 20, the first filter 40, and the second filter 60. Here, the powder P can be microparticles having a size of, e.g., micron, submicron, or nano-order. The powder P can be made of any material, but can preferably be aluminum oxide or silicon oxide.

The ALD device 200 has a gas introducing pipe 202 that is hermetically connected to the gas inlet port 30 of the reaction vessel 10 and an exhaust pipe 203 that is hermetically connected to the exhaust port 50 of the reaction vessel 10. The gas sources 100 are connected to the gas introducing pipe 202. To the exhaust pipe 203, an exhaust pump 270 is connected and is capable of vacuuming the inside of the reaction vessel 10.

The gas sources 100 include raw material gas sources 130 and a reaction gas source 140. The raw material gas sources 130 include a first raw material gas source 131 and a second raw material gas source 132. In the present embodiment, an inert gas source 170 is further disposed, to supply inert gas into the reaction vessel 10 via the gas inlet port 30 to enable to purge the inside of the reaction vessel 10. Instead of introducing a purge gas, the inside of the vessel 10 may be exhausted through the exhaust port 50 by the vacuum pump 270. Gases from these gas sources 130 (131, 132), 140, and 170 are selectively supplied to the reaction vessel 10 through the gas introducing pipe 202 with supply timing and a flow rate controlled through flow rate controllers 80A to 80D and valves 90A to 90D.

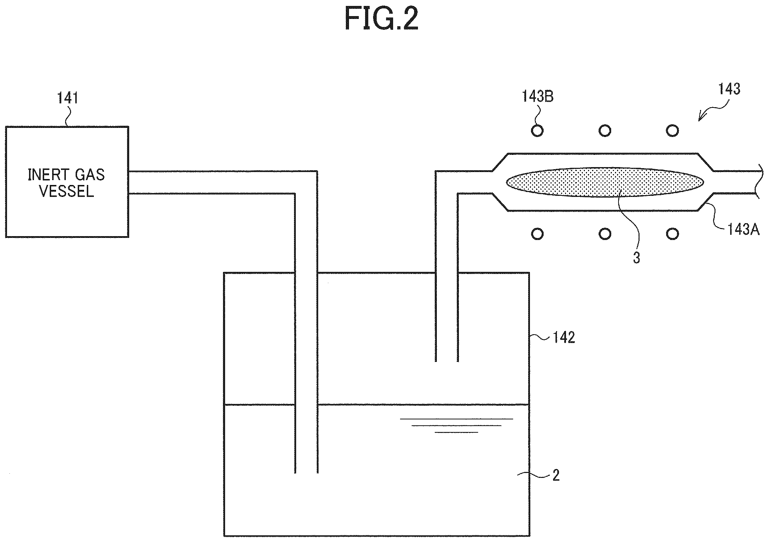

The first raw material gas source 131 supplies an organic Si compound, e.g., TDMAS (SiH[N(CH₃)₂]₃), as a first raw material gas. The second raw material gas source 132 supplies an organic Al compound, e.g., TMA (Al(CH₃)₃), as a second raw material gas. The reaction gas source 140 supplies OH radicals. The reaction gas source 140 can include a vessel 141 of the inert gas, e.g., argon Ar, a humidifier 142 containing water 2, and an activation device 143, as illustrated in FIG. 2. From the humidifier 142, water bubbled by the argon Ar is delivered as a water vapor gas. In the activation device 143, the water vapor is activated by generating plasma 3 by means of an induction coil 143B around a glass tube 143A through which humidified Ar gas passes. This results in Ar + H₂O -> Ar* + OH* + H*, and OH radicals (OH*) can be generated.

### 2. ALD Step

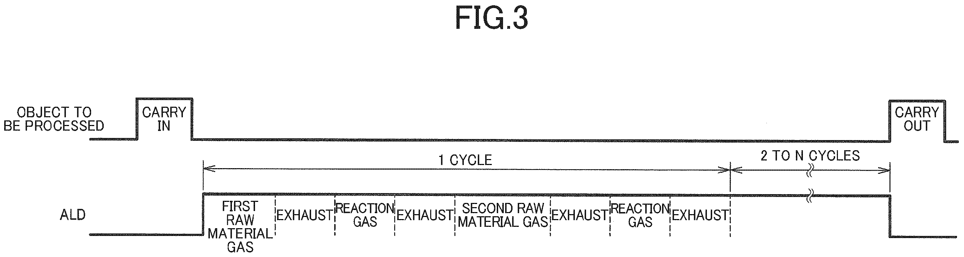

The powder P is set in the reaction vessel 10, and the ALD cycle is performed. The reaction vessel 10 in which the powder P is accommodated may be set in a dispersion device, not illustrated, to disperse the powder P. It is preferable that the powder P is dispersed before deposition, because the smaller the size of the powder P is, the easier it is to agglutinate. Generally, the ALD cycle is one cycle with a minimum of four steps: input of a raw material gas -> exhaust (purge or vacuuming) -> input of a reaction gas -> exhaust. In the embodiment, the films deposited on the powder P in the ALD device 200 are silicon oxide films and aluminum oxide films, that are alternately formed in the forward or reverse order. In the embodiment, therefore, the ALD cycle in the embodiment is defined as one cycle of input of the first raw material gas -> exhaust -> input of the reaction gas -> exhaust -> input of the second raw material gas -> exhaust -> input of the reaction gas -> exhaust, as illustrated in FIG. 3. A thickness of the film deposited on the powder P is proportional to number N of the ALD cycles. Thus, it is judged whether the number of cycles counted up at an end of each ALD cycle has reached a set value, and the ALD cycle is repeatedly performed for a required number of N cycles as illustrated in FIG. 3.

### 2.1 Silicon Oxide Film

As two types of precursors, the TDMAS (SiH[N(CH₃)₂]₃) from the first raw material gas source 131 and the hydroxyl group OH radicals (OH*) from the reaction gas source 140 are used. Upon performing the ALD cycle, the inside of the reaction vessel 10 first vacuumed by the exhaust pump 270 and set to, e.g., 10⁻⁴ Pa. Next, as a first step of the ALD cycle, the first raw material gas, the TDMAS (SiH[N(CH₃)₂]₃), is filled into the reaction vessel 10 at a predetermined pressure, e.g., 1 to 10 Pa. In the first step of the ALD cycle, The TDMAS (SiH[N(CH₃)₂]₃) permeates a surface of the powder P. After a lapse of a predetermined time, as a second step of the ALD cycle, a purge gas is introduced into the reaction vessel 10, and the TDMAS (SiH[N(CH₃)₂]₃) in the reaction vessel 10 is exhausted and replaced by the purge gas.

Next, as a third step of the ALD cycle, the hydroxyl group OH radicals (OH*) of the reaction gas are filled into the reaction vessel 10 at a predetermined pressure, e.g., 1 to 10 Pa. In the third step of the ALD cycle, the OH radicals (OH*) permeate the surface of the powder P. As a result, on the surface of the powder P, the TDMAS (SiH[N(CH₃)₂]₃) reacts with OH radicals (OH*) to form the silicon oxide SiO₄ film. In particular, on the hydroxyl groups (hydroxy groups (-OH*)) on the surface of powder P, saturated adsorption of an organic Si compound gas is possible even at room temperature. Therefore, there is no need to forcibly heat the powder P during deposition. After a lapse of a predetermined time, as a fourth step of the ALD cycle, the purge gas is introduced into the reaction vessel 10, and the OH radicals (-OH*) in the reaction vessel 10 are replaced by the purge gas. Thereby, a deposition step of the silicon oxide film is completed.

### 2.2 Aluminum Oxide Film

As two types of precursors, the TMA (Al(CH₃)₃) from the second raw material gas source 132 and the hydroxyl group OH radicals (OH*) from the reaction gas source 140 are used. First, the inside of the reaction vessel 10 is vacuumed by the exhaust pump 270 and set to, e.g., 10⁻⁴ Pa. Next, as a fifth step of the ALD cycle, the second raw material gas, the TMA (Al(CH₃)₃), is filled into the reaction vessel 10 at a predetermined pressure, e.g., 1 to 10 Pa. In the fifth step of the ALD cycle, the TMA (Al(CH₃)₃) permeates the surface of the powder P. After a lapse of a predetermined time, as a sixth step of the ALD cycle, the purge gas is introduced into the reaction vessel 10, and the TMA (Al(CH₃)₃) in the reaction vessel 10 is exhausted and replaced by the purge gas.

Next, as a seventh step of the ALD cycle, the hydroxyl group OH radicals (OH*) of the reaction gas are filled into the reaction vessel 10 at a predetermined pressure, e.g., 1 to 10 Pa. In the seventh step of the ALD cycle, the OH radicals (OH*) permeate the surface of the powder P. As a result, on the surface of the powder P, the TMA (Al(CH₃)₃) reacts with OH radicals (OH*) to form the aluminum oxide AlO₄ film. In particular, on the hydroxyl groups (hydroxy groups (-OH*)) on the surface of the powder P, saturated adsorption of an organic Al compound gas is possible even at room temperature. After a lapse of a predetermined time, as an eighth step of the ALD cycle, the purge gas is introduced into the reaction vessel 10, and the OH radicals (-OH*) in the reaction vessel 10 are replaced by the purge gas. Thereby, a deposition step of the aluminum oxide film is completed.

### 3. Formation of Zeolite Membrane

A zeolite membrane is formed by regularly arranging the silicon oxide SiO₄ films and the aluminum oxide AlO₄ films. This is because a basic unit of a zeolite structure is a tetrahedral structure of SiO₄ or AlO₄, and the units are linked in a three-dimensional direction to form a crystal. It is laminate of two types of layers at a moment of adsorption-oxidation, but it changes into a thermodynamically stable system (i.e., zeolite) with time.

### 4. Gas Adsorbent and Gas Adsorption Device

The powder P coated with the zeolite membrane can be suitably used as a gas adsorbent. The zeolite membrane has, e.g., a higher adsorption rate of nitrogen in air than that of oxygen. Therefore, the powder P coated with the zeolite membrane can be utilized in medical equipment that takes air into the equipment and produces highly concentrated oxygen from that air.

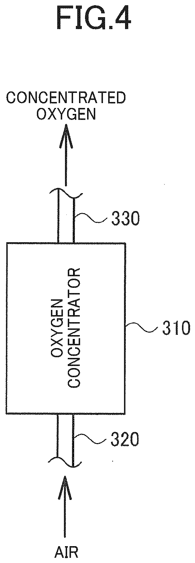

FIG. 4 illustrates a respiratory oxygen concentrator 300, that is one example of a gas adsorption device. The respiratory oxygen concentrator 300 has an oxygen concentration part 310, an introductory part 320 for introducing air into the oxygen concentration part 310, and a withdrawal part 330 from which oxygen enriched gas is withdrawn from the oxygen concentration part 310. In the oxygen concentration part 310, a plurality of powders P coated with the zeolite membrane are densely arranged in air passages. Alternatively, within the oxygen concentration part 310, a porous body in which the plurality of powders P coated with the zeolite membrane are densely disposed are arranged in the air passages. In the air introduced into the oxygen concentration part 310 from the introductory part 320, relatively more nitrogen is adsorbed than oxygen, so that the oxygen is enriched in the oxygen concentration part 310 and is then withdrawn out from the withdrawal part 330. The object on which the zeolite membrane is formed is not limited to powders or porous materials, and may be any object on which the zeolite membrane needs to be formed.

### REFERENCE SIGN LIST

- 10: reaction vessel
- 100: gas sources
- 130: raw material gas sources
- 131: first raw material gas source
- 132: second raw material gas source
- 140: reaction gas source
- 170: inert gas source
- 80A to 80D: flow rate controllers
- 90A to 90D: valves
- 200: ALD device
- 202: gas introducing pipe
- 203: exhaust pipe
- 300: gas adsorption device (respiratory oxygen concentrator)
- 310: oxygen concentration part
- 320: introductory part
- 330: withdrawal part
- P: object (powder)

## Claims

1. A zeolite membrane production method for forming a zeolite membrane on a surface of an object by performing an ALD cycle in a reaction vessel,
the ALD cycle including a silicon oxide film forming step and an aluminum oxide film forming step,
the silicon oxide film forming step including:
a first step of filling an organic Si compound as a first raw material gas into the reaction vessel,
a second step of exhausting the first raw material gas from the reaction vessel,
a third step of filling OH radicals as a reaction gas into the reaction vessel, and
a fourth step of exhausting the reaction gas from the reaction vessel,
the aluminum oxide film forming step including:
a fifth step of filling an organic Al compound as a second raw material gas into the reaction vessel,
a sixth step of exhausting the second raw material gas from the reaction vessel,
a seventh step of filling OH radicals as a reaction gas into the reaction vessel,
an eighth step of exhausting the reaction gas from the reaction vessel, and
the silicon oxide films and the aluminum oxide films being alternately formed in forward or reverse order.

2. The zeolite membrane production method according to claim 1, wherein
the object is powder, and the zeolite membrane is formed on a surface of the powder.

3. The zeolite membrane production method according to claim 2, wherein
the powder is formed of aluminum oxide, and
the silicon oxide film is formed on a surface of the powder by performing the silicon oxide film forming step first in the ALD cycle.

4. The zeolite membrane production method according to claim 2, wherein
the powder is formed of silicon oxide, and
the aluminum oxide film is formed on a surface of the powder by performing the aluminum oxide film forming step first in the ALD cycle.

5. The zeolite membrane production method according to claim 1, wherein
the object is a porous material, and the zeolite membrane is formed on a surface of the porous material.

6. A gas adsorbent comprising
a powder and
a zeolite membrane covering a surface of the powder.

7. A gas adsorption device constituted by arranging a plurality of gas adsorbents densely, the plurality of gas adsorbents including the gas adsorbent according to claim 6.
